# EUROPEAN PATENT APPLICATION

(11) **EP 4 293 713 A1**
(43) Date of publication of application: **20.12.2023**
(21) Application number: 22771438.3
(22) Date of filing: 15.03.2022
(51) Int. Cl.: H01L 23/15, H01L 23/373, C04B 35/587, H05K 1/03

(54) **SILICON NITRIDE SUBSTRATE**

(30) Priority: 19.03.2021 JP 2021045314
(71) Applicant: Proterial, Ltd., Tokyo 135-0061 (JP)
(72) Inventor: KAGA, Youichirou, Tokyo 108-8224 (JP); FUKUMOTO, Rei, Tokyo 108-8224 (JP); SHIMADA, Kei, Tokyo 108-8224 (JP)
(74) Representative: Barker Brettell LLP
(86) International application number: PCT/JP2022/011656
(87) International publication number: WO 2022/196693

(57) **Abstract**

When a large-sized silicon nitride substrate having high thermal conductivity is produced, a portion where the thermal conductivity is low is generated, which causes reduction in yield (pass rate). Provided is a silicon nitride substrate in which λe/λc, which is a ratio of a thermal conductivity λc at a center portion of the substrate to a thermal conductivity λe at an end portion of the substrate, is 0.85 to 1.15. Preferably, the silicon nitride substrate has a size of 150 mm×150 mm or more. In the silicon nitride substrate, the λc and the λe each are preferably 100 W/m·K or more.

## Description

### TECHNICAL FIELD

The present invention relates to a silicon nitride substrate used in a semiconductor module or a power module.

### BACKGROUND ART

A circuit board formed by bonding a ceramic substrate and a metal plate together is used for a semiconductor module, a power module, and the like. The ceramic substrate uses silicon nitride. In recent years, however, a silicon nitride substrate having high thermal conductivity has been considered.

A silicon nitride substrate having a high thermal conductivity (approximately 120 W/m·K) is disclosed in, for example, Patent Document 1 (Japanese Unexamined Patent Application Publication No. 2018-184333).

### PRIOR ART DOCUMENTS

### PATENT DOCUMENTS

Patent Document 1: Japanese Unexamined Patent Application Publication No. 2018-184333

### SUMMARY OF THE INVENTION

### PROBLEMS TO BE SOLVED BY THE INVENTION

When the silicon nitride substrate having high thermal conductivity described in Patent Document 1 is produced in a large size, for example, exceeding 100 mm on one side, the thermal conductivity in the silicon nitride substrate becomes non-uniform sometimes. For example, a difference is generated between the thermal conductivity at a center portion of the silicon nitride substrate and the thermal conductivity at an end portion thereof. If the silicon nitride substrate has a portion where the thermal conductivity is low, heat dissipation in the portion where the thermal conductivity is low becomes poor, and heat dissipation of the entire substrate may be affected. In addition, in a case where a plurality of circuit boards are produced by forming regions of the plurality of circuit boards on the silicon nitride substrate having high thermal conductivity and cutting the silicon nitride substrate into the regions, if there is a portion where the thermal conductivity is low, heat dissipation of the circuit board formed from the portion may be affected. When a large-sized silicon nitride substrate having high thermal conductivity is produced, there is a problem that the thermal conductivity becomes non-uniform and the yield (pass rate) becomes low.

An object of the present invention is to reduce non-uniformity in thermal conductivity in a silicon nitride substrate and provide the substrate with a high yield.

### MEANS FOR SOLVING THE PROBLEMS

Inventors have found that it is possible to produce a silicon nitride substrate with reduced non-uniformity in thermal conductivity in the substrate by reducing non-uniform nitriding of Si in the substrate in a nitriding step at the time of producing the silicon nitride substrate.

In the silicon nitride substrate of the present invention, λe/λc, which is a ratio of a thermal conductivity λc at a center portion of the substrate to a thermal conductivity λe at an end portion of the substrate, is 0.85 to 1.15.

It is preferred that the silicon nitride substrate of the present invention has a size of 150 mm×150 mm or more.

In the silicon nitride substrate of the present invention, the λc and the λe each are preferably 100 W/m·K or more.

According to the present invention, it is possible to reduce non-uniformity in thermal conductivity in the silicon nitride substrate and obtain the substrate with a high yield.

### BRIEF DESCRIPTION OF THE DRAWINGS

FIG. 1 is a schematic view explaining a stacked state of green sheets.
FIG. 2 is a schematic view explaining the stacked state following FIG. 1.
FIG. 3 is a schematic view explaining the stacked state following FIG. 2 and a state of being carried into a nitriding apparatus.
FIG. 4(a) is a top view and FIG. 4(b) is a schematic cross-sectional view taken along line A1-A1, for explaining a member 30a according to an embodiment, with respect to FIG. 3.
FIG. 5(a) is a top view, FIG. 5(b) is a schematic cross-sectional view taken along line A2-A2, and FIG. 5(c) is a front view, for explaining a vertical frame member 30b according to a reference example, with respect to FIG. 3.
FIG. 6(a) is a top view, FIG. 6(b) is a schematic cross-sectional view taken along line A3-A3, and FIG. 6(c) is a front view, for explaining a member 30c according to the reference example, with respect to FIG. 3.

### MODE FOR CARRYING OUT THE INVENTION

Embodiments of the present invention will be described hereinafter, but the present invention is not necessarily limited thereto. The description of each embodiment can be applied to other embodiments unless otherwise specified.

### [1] Production method of a silicon nitride substrate

### (1) Step of preparing a slurry

In the method of the present invention, a slurry is prepared by pulverizing a raw material powder, which is obtained by adding a rare earth element oxide and a magnesium compound as sintering aids to a silicon powder, by a method such as media dispersion.

### (a) Silicon

A silicon powder of an industrially available grade can be used as the silicon used in the present invention. The silicon before pulverization is preferably a powder having a median diameter D50 of 6 µm or more, a BET specific surface area of 3 m²/g or less, an amount of oxygen of 1.0% by mass or less, and an amount of impurity C in the silicon of 0.15% by mass or less, and more preferably a powder having a median diameter D50 of 7 µm or more, a BET specific surface area of 2.5 m²/g or less, an amount of oxygen of 0.5% by mass or less, and an amount of impurity C in the silicon of 0.10% by mass or less. The silicon powder has a purity of preferably 99% or more, and more preferably 99.5% or more. Impurity oxygen contained in silicon is one of factors that hinders heat conduction of a silicon nitride substrate obtained by reaction sintering. Therefore, it is preferred that an amount of impurity oxygen contained in the silicon is as small as possible. Further, in the present invention, the raw material powder is preferably adjusted by limiting the amount of oxygen from the magnesium compound, as later described, so that a total amount of impurity oxygen contained in the silicon powder and oxygen from the magnesium compound is in a range of 0.1 to 1.1% by mass relative to the silicon converted to silicon nitride. Also, impurity carbon contained in silicon hinders growth of silicon nitride grains in a silicon nitride substrate obtained by reaction sintering. As a result, densification of silicon becomes insufficient, which is one of factors that reduce heat conduction and insulation.

Herein, the BET specific surface area (m²/g) is a value obtained by a single point BET method (JIS R 1626:1996 "Measuring methods for the specific surface area of fine ceramic powders by gas absorption using the BET method") using a BET specific surface area meter, and the median diameter D50 (µm) is a grain diameter when a cumulative frequency is 50% in a grain size distribution obtained by a laser diffraction and scattering method.

Although it is not required in the production method of the present invention, the raw material powder may include a silicon nitride powder. However, use of silicon nitride requires more cost than in a case of using silicon. Therefore, it is preferred that an amount of silicon nitride used is as small as possible. The mount of silicon nitride used is preferably 20 mol% or less of silicon (in terms of silicon nitride), more preferably 10 mol% or less, and further more preferably 5 mol% or less.

### (b) Rare earth element oxide

The rare earth element oxide used in the present invention is preferably an easily available oxide such as Y, Yb, Gd, Er, Lu, etc. that are stable as an oxide. Examples of the rare earth element oxide includes Y₂O₃, Yb₂O₃, Gd₂O₃, Er₂O₃, Lu₂O₃, etc. A content of the rare earth element oxide is 0.5 mol% or more and less than 2 mol% relative to a sum of silicon (in terms of silicon nitride), a rare earth element oxide (in terms of trivalent oxide) and a magnesium compound (in terms of MgO). If the content of the rare earth element oxide is less than 0.5 mol%, it is not preferable since the effect as a sintering aid becomes insufficient, resulting in insufficient density. If the content of the rare earth element oxide is 2 mol% or more, it is not preferable since thermal conductivity of a sintered body decreases due to increase of a grain boundary phase having low thermal conductivity, and an amount used of the rare earth element oxide, which is expensive, increases. The content of the rare earth element oxide is preferably 0.6 mol% or more and less than 2 mol%, and more preferably 1 mol% or more and less than 1.8 mol%.

In the present application, a sum of the number of moles of silicon nitride (Si₃N₄) obtained when all the silicon is nitrided, the number of moles of the rare earth element oxide when converted to trivalent oxide RE₂O₃ (RE indicates rare earth element), and the number of moles of the magnesium compound when converted to MgO may be simply referred to as "the sum of silicon (in terms of silicon nitride), rare earth element oxide (in terms of trivalent oxide) and magnesium compound (in terms of MgO)".

### (c) Magnesium compound

As the magnesium compound, one or more types of magnesium compound containing Si, N or O can be used. Specifically, it is preferred to use magnesium oxide (MgO), magnesium silicon nitride (MgSiN₂), magnesium silicide (Mg₂Si), magnesium nitride (Mg₃N₂), etc. Here, the magnesium compound is selected so that 87% by mass or more of the total magnesium compound is MgSiN₂. Use of 87% by mass or more of MgSiN₂ can reduce oxygen concentration in the silicon nitride substrate obtained. If MgSiN₂ in the magnesium compound is less than 87% by mass, it is not preferable since, due to the increased amount of oxygen in the sintered silicon nitride grains, the thermal conductivity of the sintered body becomes low. The magnesium compound includes preferably 90% by mass or more of MgSiN₂.

A content of the magnesium compound (in terms of MgO) in the silicon nitride substrate is 8 mol% or more and less than 15 mol% relative to the sum of silicon (in terms of silicon nitride), rare earth element oxide (in terms of trivalent oxide) and magnesium compound (in terms of MgO). If the content of the magnesium compound is less than 8 mol%, it is not preferable since the effect as a sintering aid becomes insufficient, resulting in insufficient density. If the content of the magnesium compound is 15 mol% or more, it is not preferable since the thermal conductivity of the sintered body decreases due to increase of the grain boundary phase having low thermal conductivity. The content of the magnesium compound is preferably 8 mol% or more and less than 14 mol%, and more preferably 9 mol% or more and less than 13 mol%.

### (d) Pulverization

The rare earth element oxide and the magnesium compound are added as sintering aids to the silicon powder in a specified ratio, and a dispersion medium (organic solvent), and a dispersant, if necessary, are added. Pulverization is performed with a ball mill to prepare the slurry (dispersion of the raw material powder). It is preferred that media have a diameter of 5 mm or more and a concentration of the raw material powder in the slurry (also referred to as slurry concentration) is 40% by mass or more. Pulverization is preferably performed for 6 hours or more. The media used are preferably made from a material that does not contain Al or Fe as a main component, which is a factor that lowers the thermal conductivity of silicon nitride. It is especially preferred that media are made of silicon nitride. Types of the dispersion medium and the dispersant are not specifically limited, and can be selected as required depending on a method of molding a sheet, etc.

As the dispersion medium, ethanol, n-butanol, toluene, MEK, MIBK, etc. can be used. As the dispersant, for example, a sorbitan ester type dispersant, a polyoxyalkylene type dispersant, etc. can be used. Preferably, an amount of the dispersion medium used is, for example, 40 to 70% by mass relative to the total amount of the powder. Preferably, an amount of the dispersant used is, for example, 0.3 to 2% by mass relative to the total amount of the powder. The dispersion medium may be removed after dispersion or replaced with other dispersion medium as required.

Time for pulverization is not specifically limited since it varies depending on a milling device used, an amount and properties of a starting material, etc. It is preferred that the time is selected so that the raw material powder can be sufficiently pulverized and mixed. The preferred pulverization time may be, for example, 6 hours or more and 48 hours or less, and more preferably 12 hours or more and 24 hours or less. If the pulverization time is too short, sufficient pulverization cannot be performed and it may not be possible to obtain a pulverized silicon powder that satisfies the conditions of the present invention. If the pulverization time is too long, an amount of impurity oxygen gradually increases, and the thermal conductivity of the silicon nitride substrate may decrease.

The pulverized silicon grains have an amount of oxygen of preferably 1.0% by mass or less, and more preferably 0.7% by mass or less. The silicon grains having as little amount of oxygen as possible can improve the thermal conductivity of the silicon nitride. Since it is difficult to measure the amount of oxygen in only the silicon grains after mixing with the sintering aids, a slurry of only the silicon grains that is not mixed with the sintering aids may be prepared as a sample under the same pulverization conditions. Then, this slurry can be used for the measurement of the amount of oxygen in the silicon grains. For example, the silicon grains are extracted from the slurry, and the amount of oxygen in the silicon grains is measured using an oxygen analyzer based on an inert gas fusion-nondispersive infrared absorption method.

The BET specific surface area (m²/g), the median diameter D50 (µm) and the amount of oxygen in the silicon grains in the slurry obtained by pulverization are values measured using the silicon grains pulverized in the same manner except that no rare earth element oxide or magnesium compound is added. Since only a small amount of the rare earth element oxide powder and the magnesium compound powder are added to the silicon powder, pulverization efficiency is barely affected. It is believed that the values obtained in this way are substantially the same as the silicon grains in the slurry.

### (2) Step of obtaining a sheet-like molded body (molding step)

The dispersion medium, an organic binder, the dispersant, etc. are added as required to the obtained slurry. Then, vacuum deforming is carried out as required, and viscosity of the slurry is adjusted to a specified range, so that a coating slurry is prepared. It is preferred that the viscosity of the slurry is adjusted to 1 Pa s or more and less than 15 Pa s. The viscosity of the slurry is a value measured using a rotary viscometer at a temperature of 25°C and a rotation speed of 10 rpm. In some cases, the dispersion medium may be removed or replaced as described above. After the prepared coating slurry is molded into a sheet using a sheet molding machine and the sheet is cut into a specified size, drying is performed to obtain a sheet-like molded body. The organic binder used in preparing the coating slurry is not specifically limited, and may be a PVB resin (polyvinyl butyral resin), an ethyl cellulose-based resin, an acrylic resin, etc. It is preferred that added amounts of the dispersion medium, the organic binder, the dispersant, etc. are appropriately adjusted depending on coating conditions.

The method of molding the coating slurry into a sheet is not specifically limited, and a sheet molding method such as a doctor blade method, an extrusion molding method, etc. can be used. In the production method of a silicon nitride substrate of the present embodiment, a damaged layer is not formed and thus there is no need for removal. Therefore, it is not necessary to consider a thickness of the damaged layer. Accordingly, sheet molding which allows easy molding into a thin sheet can be preferably used.

When the coating slurry is molded into a sheet by a doctor blade method or an extrusion molding method, it is preferred that a molding speed of the coating slurry is 600 mm/min or less. The coating slurry used in the present invention has thixotropic properties. Thus, when the coating slurry passes through a doctor blade based on the doctor blade method or a mold based on the extrusion method, a shearing stress is applied to the coating slurry, and the viscosity of the coating slurry decreases. Accordingly, if the molding speed exceeds 600 mm/min, the coating slurry flows easily and tends to involve bubbles that cause pores, which may hinder the densification.

A drying speed of the coating slurry is preferably 0.8% by mass/min or less. If the drying speed of the coating slurry exceeds 0.8% by mass/min, the dispersion medium volatilizes rapidly, and air bubbles may easily form in the sheet. The sheet after coated is passed through a drying zone so as to be gradually heated and dried, so the drying speed in the drying process is not constant but fluctuates. Thus, it is preferred that the maximum drying speed does not exceed 0.8% by mass/min.

A thickness of the sheet-like molded body formed in the molding step is, for example, 0.15 to 0.8 mm. The sheet-like molded body obtained can be cut into a specified size as required, for example, by a punching machine, etc.

### (3) Step of sintering a molded body (sintering step)

The sheet-like molded body obtained is heated to nitride the silicon contained in the molded body, and thereafter is densified. The sintering step includes a degreasing step for removing the organic binder in the molded body, a nitriding step for reacting and nitriding Si and nitrogen contained in the molded body, and a densification sintering step for densification after the nitriding. These steps may be performed sequentially in separate furnaces, or successively in the same furnace. Conditions for members (for example, plates and frames) provided around a stacked assembly in which the sheet-like molded bodies (green sheets) are stacked can be changed between the nitriding step and the densification sintering step.

For example, one sheet of the sheet-like molded body prepared, or a plurality of sheets of the sheet-like molded bodies with a separation material interposed therebetween, is stacked on a BN plate and set within an electric furnace. After degreasing (removing the organic binder, etc.), the molded body can be decarbonized in a nitriding apparatus at 900 to 1300°C, heated to a specified temperature under a nitrogen atmosphere and nitrided, thereafter sintered in a sintering apparatus. At this time, it is preferred that the molded body is heated while receiving a load of 10 to 1000 Pa. Preferably, degreasing is carried out at a temperature of 800°C or less.

When a plurality of sheet-like molded bodies are stacked, it is preferred to use a boron nitride (BN) powder having a thickness of approximately 3 to 20 µm as the separation material. A BN powder layer is for facilitating separation of the silicon nitride sintered body substrate after sintering. The BN powder layer can be formed, for example, by spraying, brushing or screen printing the slurry including the BN powder on one side of each sheet-like molded body. Preferably, the BN powder has a purity of 95% or more and an average grain diameter (D50) of 1 to 20 µm.

In the nitriding step, a nitrogen partial pressure during nitriding is preferably 0.05 to 0.7 MPa, and more preferably 0.07 to 0.2 MPa. The nitriding temperature is preferably 1350 to 1500°C, and more preferably 1400 to 1450°C. A retention time after heated to the nitriding temperature is preferably 3 to 12 hours, and preferably 5 to 10 hours. If the nitriding temperature is less than 1350°C, or the retention time is less than 3 hours, unreacted silicon powder may remain in the sheet-like molded body, and it may not be possible to obtain a dense body by the densification sintering step carried out after the nitriding step. If the nitriding temperature exceeds 1500°C, the silicon powder melts before nitriding and may remain without being nitrided, or a sintering aid component volatilizes and becomes insufficient in the densification sintering step, which may make it difficult to obtain a dense sintered body. If the retention time exceeds 12 hours, a sintering aid component volatilizes and becomes insufficient in the densification sintering step, which may make it difficult to obtain a dense sintered body.

The nitrogen partial pressure during densification sintering is preferably 0.1 to 0.9 MPa, and more preferably 0.5 to 0.9 MPa. A sintering temperature is preferably 1800 to 1950°C, and more preferably 1850 to 1900°C. The retention time (sintering time) after heated to the sintering temperature is preferably 3 to 12 hours, and preferably 5 to 12 hours. If the sintering temperature is less than 1800°C or the retention time is less than 3 hours, it may not be possible to obtain a dense body due to insufficient growth and rearrangement of the silicon nitride grains. If the sintering temperature exceeds 1950°C or the retention time exceeds 12 hours, the sintering aid component volatilizes and becomes insufficient, which may make it difficult to obtain a dense sintered body.

### [2] Silicon nitride substrate

The silicon nitride substrate of the present invention is a silicon nitride substrate obtained by nitriding the silicon contained in the sheet-like molded body, and λe/λc, which is a ratio of a thermal conductivity λc at a center portion of the substrate and a thermal conductivity λe at an end portion of the substrate, is 0.85 to 1.15. The silicon nitride substrate is shaped to have a first main surface, a second main surface, and four side surfaces. The first main surface or the second main surface has a center portion and an end portion in the surface. The thermal conductivity λc at the center portion of the substrate and the thermal conductivity λe at the end portion of the substrate each are preferably 100 W/m·K or more, more preferably 110 W/m·K, further more preferably 120 W/m·K or more, and particularly preferably 130 W/m·K or more.

### (1) Composition

The silicon nitride substrate after sintering contains β-phase silicon nitride as a main component, and contains a rare earth element and a magnesium. The rare earth element may be a single state, or may form a compound with other substances. The magnesium contained in the silicon nitride substrate may be a single state, or may be a compound with other substances.

The silicon nitride substrate of the present invention is a silicon nitride sintered body including silicon nitride grains and a grain boundary phase that forms a grain boundary of the silicon nitride grains. A content of the rare earth element (in terms of trivalent oxide RE₂O₃ (RE indicates rare earth element)) in the grain boundary phase is preferably 0.5 to 2.3 mol% and a content of the magnesium (in terms of MgO) is preferably 0.5 to 10 mol%. In the silicon nitride substrate of the present application, the content of the rare earth element and the content of the magnesium are values obtained by taking a sum of the number of moles of silicon nitride (Si3N4), the number of moles of the rare earth element when converted to trivalent oxide RE₂O₃ (RE indicates rare earth element), and the number of moles of the magnesium when converted to MgO as 100 mol%. Hereinafter, the sum may be simply referred to as "the sum of silicon nitride, rare earth element (in terms of trivalent oxide) and magnesium (in terms of MgO)".

Here, a sum of the content of the rare earth element (in terms of trivalent oxide RE₂O₃ (RE indicates rare earth element)) and the content of the magnesium (in terms of MgO) in the grain boundary phase (total amount of the grain boundary phase) is preferably 1.0 to 12.3 mol%.

The contents of silicon nitride, rare earth element and magnesium of in the silicon nitride substrate depend on the added amounts of the silicon powder at the time of production, and of the rare earth element oxide and the magnesium compound as the sintering aids. In the method of the invention of the present application, since mainly the magnesium compound decreases due to volatilization during firing, the content of the magnesium in the silicon nitride substrate after sintering is reduced relative to the added amount at the time of production. On the other hand, since the rare earth element oxide hardly volatilizes, its content rate relative to the sum of silicon nitride, rare earth element (in terms of trivalent oxide) and magnesium (in terms of MgO) may slightly increase due to reduction of the magnesium compound. A volatilization volume of the magnesium compound varies depending on the shape of the molded body, firing conditions, etc.

An amount of oxygen in the silicon nitride grains is less than 0.05% by mass. If the amount of oxygen exceeds 0.05% by mass, high thermal conductivity cannot be obtained. As samples, two silicon nitride substrates may be prepared under the same condition, and one of the silicon nitride substrates can be used as a substrate, and the other of the silicon nitride substrates can be used for measurement of the amount of oxygen. For example, the other of the silicon nitride substrates is pulverized and pickled so as to extract the silicon nitride grains (remove the grain boundary phase by pickling), and measures the amount of oxygen in the silicon nitride grains using an oxygen analyzer based on the inert gas fusion-nondispersive infrared absorption method.

### (3) Others

It is preferred that the silicon nitride substrate has a dense structure having a relative density of 98% or more. If the relative density of the silicon nitride substrate is less than 98%, high thermal conductivity cannot be achieved. In the dense silicon nitride substrate as such, heat conduction is less likely to hindered by voids, and particularly the silicon nitride substrate of the present invention has a thermal conductivity of 115 W/m·K or more in a thickness direction.

A bending strength of the silicon nitride substrate is, for example, 600 MPa or more. In a case of a silicon nitride circuit board for a power module in which a circuit such as a copper plate is bonded to a silicon nitride substrate through a brazing material, a high stress is applied during mounting and driving. Thus, although it depends on the method, it is preferred that the bending strength is 600 MPa or more. Also, since the bending strength is as high as 600 MPa or more, it is possible to make the silicon nitride substrate thinner.

The thickness of the silicon nitride substrate is not specifically limited, and can be any thickness. For example, if the silicon nitride substrate is used as a semiconductor device or an insulated heat dissipation substrate of an electronic device, the thickness is preferably 0.05 to 2.5 mm, more preferably 0.1 to 1 mm, and further more preferably 0.2 to 0.6 mm especially when the silicon nitride substrate is used as a silicon nitride circuit board for a power module. The thickness of the silicon nitride substrate after sintering can be adjusted by adjusting the thickness of the sheet molded body formed in the sheet molding step.

### EXAMPLES

The present invention will be described in more detail by way of examples, but the present invention is not limited to those examples.

### (1) Preparation of a silicon nitride substrate of Example 1

### (Slurry preparation step)

To a silicon powder having a BET specific surface area of 2.1 m²/g, a median diameter D50 of 8.2 µm, and an amount of oxygen of 0.3% by mass, 1.2 mol% of Y₂O₃ powder and 9.8 mol% of MgSiN₂ powder relative to the sum of silicon (in terms of silicon nitride), rare earth element oxide (in terms of trivalent oxide) and magnesium compound (in terms of MgO) were added as sintering aids to obtain a raw material powder. To the raw material powder, 0.5% by mass of a dispersant (sorbitan acid trioleate) relative to a sum of dispersion medium (toluene) and the raw material powder was added to prepare a slurry having a concentration of 42% by mass, and the slurry was pulverized for 24 hours by a ball mill using a 5φ ball made of silicon nitride as a medium. The amount of the magnesium compound added is expressed in mol% when all the magnesium compound is converted to MgO. The BET specific surface area, the median diameter D50, and the amount of oxygen in the silicon powder before pulverization were measured using a BET specific surface area meter based on a single point BET method, a grain size distribution meter based on a laser diffraction and scattering method, and an oxygen analyzer based on an inert gas fusion-nondispersive infrared absorption method, respectively.

### (Sheet molding step)

The obtained slurry was adjusted in concentration by adding a dispersion medium and an organic binder (acrylic resin), and subjected to defoaming treatment to obtain a slurry-like coating liquid. The coating slurry was applied to a carrier film by a doctor blade method. The coated carrier film was molded into a sheet having a thickness of 0.38 mm, and cut into a size of 240 mm×200 mm to obtain a sheet-like molded body. A speed at which the carrier film is fed during coating corresponds to a molding speed, and the molding speed was 600 mm/min or less.

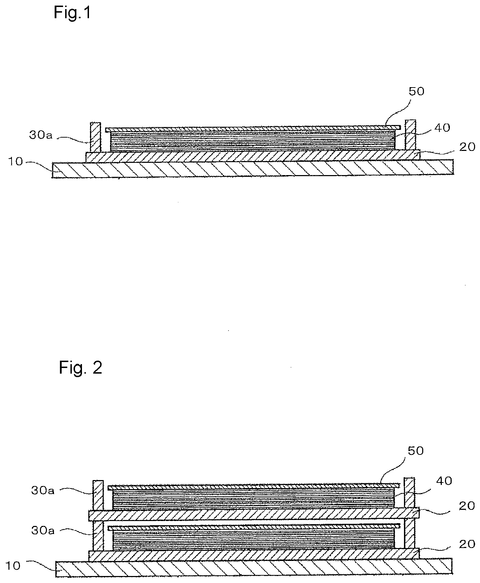

A plurality of the sheet-like molded bodies obtained were stacked with a BN powder layer (thickness of 4.5 µm) interposed therebetween to prepare a stacked assembly. The stacked assembly was placed on a BN plate (carrying plate) and multistaged as shown in schematic views of FIGS. 1 and 2 while being surrounded by a vertical frame member (made of BN).

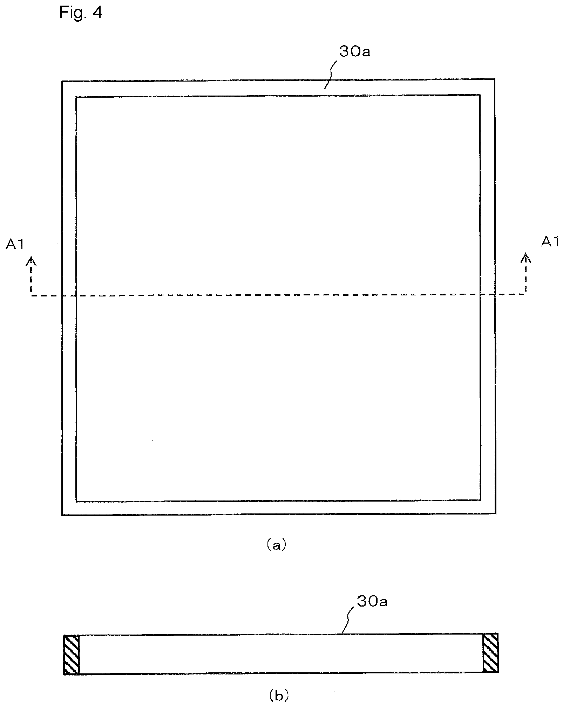

As shown in FIG. 1, the carrying plate (made of BN) 20 was placed on a top surface of a bottom plate (holding plate) 10, and the stacked assembly 40 including a plurality of green sheets and a top plate (weight plate) 50 made of BN were placed thereon. Next, a vertical frame member 30a made of BN (made of boron nitride) shown in FIG. 4 was set on an outer circumference of the carrying plate 20. As shown in FIG. 2, the next-stage carrying plate 20 was placed on the vertical frame member 30a, and the stacked assembly 40 and the top plate (weight plate) 50 were placed on the carrying plate 20. In this manner, the carrying plate assembly 70 including a desired number of stacked assemblies 40 and top plates (weight plates) 50, and the carrying plate 60 mounted on the uppermost vertical frame member 30a (type of FIG. 4) was prepared. Here, the vertical frame member 30a of FIG. 4 has a rectangular frame shape as shown in the top view of FIG. 4(a), which is an integral body made of BN. As shown by hatched cross-sectional portions in the schematic view of FIG. 4(b), the vertical frame member 30a has a uniform thickness.

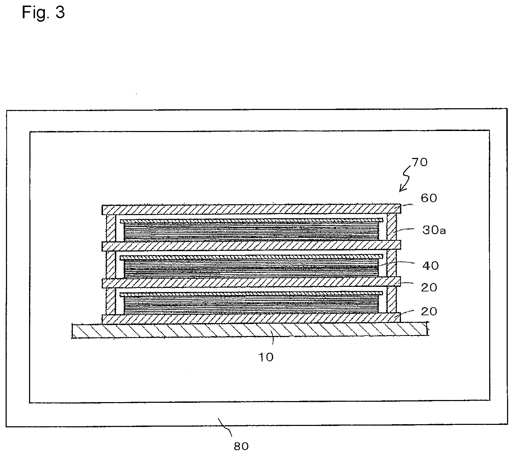

Next, degreasing was performed under a nitrogen atmosphere (nitrogen partial pressure 0.1 MPa) and at 750°C for 5 hours (degreasing step), as shown in FIG. 3. The carrying plate assembly 70 was placed in the nitriding apparatus 80 and nitrided under a nitrogen atmosphere (nitrogen partial pressure 0.5 MPa) and at 1400°C for 10 hours (nitriding step). In the nitriding step, the carrying plate assembly 70 is not housed in a BN crucible in the nitriding apparatus 80 (nitriding was performed without a crucible).

Next, the carrying plate assembly 70 that was taken out of the nitriding apparatus 80 was housed in the BN crucible, carried into the sintering apparatus, and sintered in the sintering apparatus under a nitrogen atmosphere (nitrogen partial pressure 0.9 MPa) and at 1900°C for 12 hours (densification sintering step). The BN powder layer was removed to obtain a substrate made of a silicon nitride sintered body.

Next, a liquid honing process was performed for the purpose of cleaning a surface of the silicon nitride substrate and causing the surface to have appropriate roughness. The honing process was performed by adding an appropriate amount of alumina abrasive grains into water, and spraying the alumina abrasive grains onto the front and back surfaces of the sintered body at a pressure of 0.5 MPa. The silicon nitride substrate obtained had a size of 200 mm×170 mm and a thickness of 0.32 mm.

After cleaning and the liquid honing process, the thermal conductivity λc at the center portion of the silicon nitride substrate and the thermal conductivity λe at the end portion of the silicon nitride substrate were measured. Here, the center portion is in a range of a radius of 30 mm from the center of the silicon nitride substrate (intersection of a diagonal line of the substrate), and a test piece of 10 mm square was cut out from the range of the center portion. The end portion is in a range of a radius of 40 mm from a corner (any one of four corners) of the silicon nitride substrate, and a test piece of 10 mm square was cut out from the range of the end portion. The thermal conductivity was measured by a flash method using each test piece cut out into 10 mm square. The results are shown in Table 1.

**[Table 1]**

| | SILICON NITRIDE SUBSTRATE | | | PRODUCTION CONDITIONS | | |
|---|---|---|---|---|---|---|
| | THERMAL CONDUCTIVITY λc AT CENTER PORTION | THERMAL CONDUCTIVITY λe AT END PORTION | Ae/Ac | SINTERING AID | DEGREASING CONDITIONS | NITRIDING CONDITIONS |
| EXAMPLE 1 | 117 | 116 | 0.99 | MgSiN₂, Y₂O₃ | IN NITROGEN | 1400°C-10h, 0.5 MPa (FIG. 4) |
| EXAMPLE 2 | 122 | 121 | 0.99 | MgSiN₂, Y₂O₃ | IN ATMOSPHERE | 1400°C-10h, 0.1 MPa (FIG. 4) |
| EXAMPLE 3 | 130 | 130 | 1.00 | MgSiN₂, Y₂O₃ | IN NITROGEN | 1450°C-10h, 0.1 MPa (FIG. 4) |
| EXAMPLE 4 | 148 | 143 | 0.97 | MgSiN₂, Y₂O₃ | IN NITROGEN | 1400°C-10h, 0.1 MPa (FIG. 4) |
| EXAMPLE 5 | 133 | 137 | 1.03 | MgSiN₂, Y₂O₃ | IN NITROGEN | 1400°C-7h, 0.1 MPa (FIG. 4) |
| REFERENCE EXAMPLE | 139 | 115 | 0.83 | MgSiN₂, Y₂O₃ | IN NITROGEN | 1450°C-10h, 0.1 MPa (FIG. 5) |

| | | | | | | |
|---|---|---|---|---|---|---|
| (Note 1) In Table 1, for example, "1400°C-10h, 0.5 MPa" corresponds to nitriding performed in the nitriding apparatus 80 under a nitrogen atmosphere (nitrogen partial pressure 0.5 MPa) and at 1400°C for 10 hours. (Note 2) Numbers of the drawings in brackets in the nitriding condition of Table 1 indicate that the vertical frame member of the drawings was used. | | | | | | |

In Example 1, when the nitriding step is performed, the carrying plate assembly 70 is not housed in the crucible corresponding to a container, and the carrying plate assembly 70 was carried and housed in the nitriding apparatus as it was. In the nitriding step, nitrogen (N element) in the atmosphere of the nitriding apparatus appropriately flows back and forth without being blocked by a crucible. As a result, it is considered that nitrogen in the atmosphere is sufficiently supplied to the large-sized sheet-like molded body of the stacked assembly 40, Si (silicon) in the sheet-like molded body is uniformly nitrided, and occurrence of non-uniform nitriding in the substrate was reduced.

### (2) Preparation of silicon nitride substrates for Examples 2 to 5

Silicon nitride substrates were prepared in the same manner as in Example 1 except that the sintering aid, degreasing conditions and nitriding conditions were changed as shown in Examples 2 to 5 in Table 1.

In the silicon nitride substrates of Example 1 to 5 of the present invention, the thermal conductivity ratios λe/λc are in a range of 0.94 to 1.03, and differences in thermal conductivity between the center portion and the end portion are reduced as compared with a reference example. In the nitriding step, it is considered that, by adopting the vertical frame member of FIG. 4 in FIGS. 1 to 3 and performing the nitriding step without housing the carrying plate assembly 70 in a crucible, variations in nitriding in the substrate were equalized. In Example 1, the λc and the λe each were 110 W/m·K or more. In Example 2, the λc and the λe each were 120 W/m·K or more. In Examples 3 to 5, the λc and the λe each were 130 W/m·K or more.

### (3) Preparation of a silicon nitride substrate of a reference example

A silicon nitride substrate was prepared in the same manner as in Example 1 except that the sintering aid, degreasing conditions and nitriding conditions were changed as shown in the reference example in Table 1.

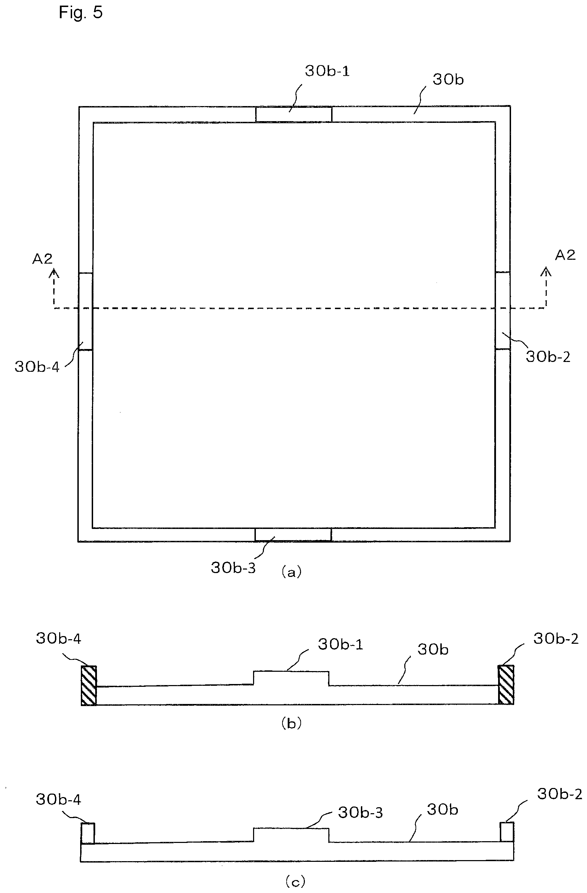

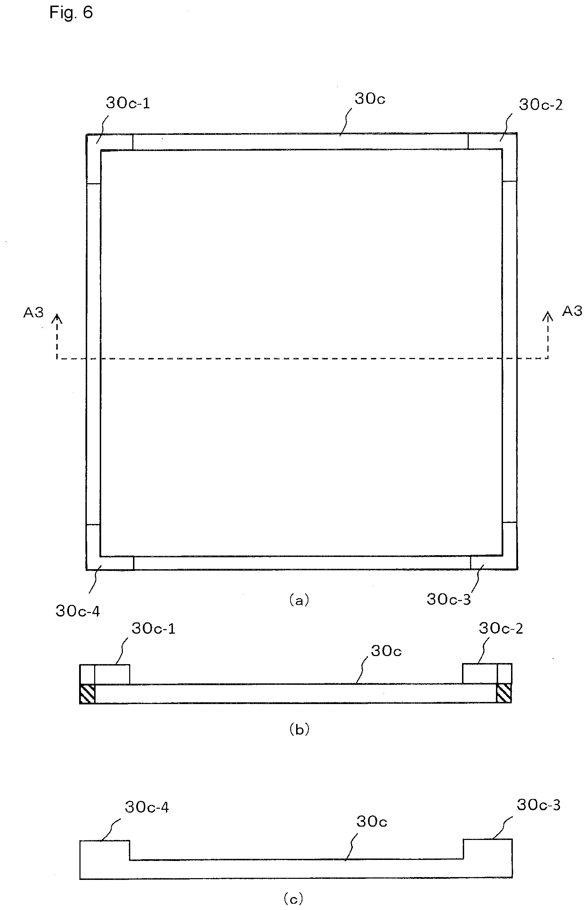

In the reference example, the vertical frame member 30b of FIG. 5 was adopted in FIGS. 1 to 3. The vertical frame member 30b of FIG. 5 has a rectangular frame shape as shown in the top view of FIG. 5(a), and includes protrusions 30b-1, 30b-2, 30b-3, and 30b-4, which have a rectangular shape (thin plate shape) when viewed from above, at the center of each of four sides. The rectangular frame and the four protrusions are formed as an integral body made of BN. In the schematic view of FIG. 5(b), a thickness of hatched cross-sectional portions (30b-4, 30b-2) is made larger than a thickness of the "frame" which is a main member of the vertical frame member 30b. Thus, as shown in the front view of FIG. 5(c), a recess is formed between the protrusions. It is possible to change the vertical frame member 30b of FIG. 5 to the vertical frame member 30c of FIG. 6. The effect of the recess is common.

The vertical frame member 30c of FIG. 6 has a rectangular frame shape as shown in the top view of FIG. 6(a), and includes protrusions 30c-1, 30c-2, 30c-3, and 30c-4, which have an L-shape when viewed from above, at four corners thereof. The rectangular frame and the four protrusions are formed as an integral body made of BN. A thickness of the protrusions 30c-4 and 30c-3 in the front view of FIG. 6(c) is made larger than a thickness of a cross-sectional portion hatched in the schematic view of FIG. 6(b). Thus, a recess is formed between the protrusions as shown in the front view of FIG. 6(c).

The silicon nitride substrate of the reference example has a thermal conductivity ratio λe/λc of 0.83. The result was that a difference between the thermal conductivity at the center portion and the thermal conductivity at the end portion increased. It was expected that, when the vertical frame member 30b of FIG. 5 is adopted in FIGS. 1 to 3, nitrogen in the atmosphere, by passing through the recess in the nitriding step, is further supplied to the large-sized sheet-like molded body of the stacked assembly 40, and nitriding of Si (silicon) in the sheet-like molded body is further promoted and equalized. However, it is considered that, at the end portion, magnesium (Mg element) as the sintering aid was more likely to be released into the atmosphere through the recess, resulting in non-uniform nitriding at the end portion.

### EXPLANATION OF REFERENCE NUMERALS

10: bottom plate (holding plate),
20: carrying plate,
30a: vertical frame member,
30b: vertical frame member,
30b-1, 30b-2, 30b-3, 30b-4: protrusion,
30c: vertical frame member,
30c-1, 30c-2, 30c-3, 30c-4: protrusion,
40: stacked assembly,
50: top plate (weight plate),
60: carrying plate,
70: carrying plate assembly,
80: nitriding apparatus

## Claims

1. A silicon nitride substrate in which λe/λc, which is a ratio of a thermal conductivity λc at a center portion of the substrate to a thermal conductivity λe at an end portion of the substrate, is 0.85 to 1.15.

2. The silicon nitride substrate according to claim 1, having a size of 150 mm×150 mm or more.

3. The silicon nitride substrate according to claim 1 or 2, wherein the λc and the λe each are 100 W/m·K or more.
